(19) Europäisches Patentamt

European Patent Office

Office européen des brevets

(11) **EP 0 820 145 B1**

(12) **EUROPEAN PATENT SPECIFICATION**

(45) Date of publication and mention
of the grant of the patent:
**11.06.2003 Bulletin 2003/24**

(51) Int Cl.⁷: **H03H 17/06**

(21) Application number: **97111709.8**

(22) Date of filing: **10.07.1997**

(54) **Interpolation filter**

Interpolationsfilter

Filtre d'interpolation

(84) Designated Contracting States:
**AT BE CH DE ES FI FR GB IT LI NL SE**

(30) Priority: **17.07.1996 GB 9615021**

(43) Date of publication of application:
**21.01.1998 Bulletin 1998/04**

(73) Proprietor: **ROKE MANOR RESEARCH LIMITED
Romsey, Hampshire, SO51 0ZN (GB)**

(72) Inventor: **Hulbert, Anthony Peter
Southamton SO15 6AN (GB)**

(74) Representative: **Condon, Neil
Siemens AG
P.O. Box 22 16 34
80506 München (DE)**

(56) References cited:
**DE-A- 4 022 387**

• **HERRMANN M: "DIGITALER
FERNSEHEMPFANGER MIT
UNVERKOPPELTEM SYSTEMTAKT TEIL 1:
KONZEPT UND THEORETISCHE
GRUNDLAGEN" FERNSEH UND
KINOTECHNIK,DE,VDE VERLAG GMBH.
BERLIN, vol. 44, no. 5, 1990, page 223-228
XP000128208 ISSN: 0015-0142**

**Description**

The present invention relates to digital signal processors which operate to interpolate discrete time signals.

As is well known to those skilled in the art, interpolation is a process wherein a value of a function or signal is estimated at a particular point from values of the function or signal already known. In the context of digital signal processing, interpolation is used to increase a sample rate of a signal represented by discrete time signal samples. The discrete time signal samples representative of the signal are typically displaced in time at regular intervals in accordance with a sampling interval of the signal. The sampling interval, and therefore the sampling rate, are determined by the bandwidth of frequencies from which the signal is comprised as determined by Nyquist Sampling Theory well known to those skilled in the art. Therefore, to increase the sampling rate of the discrete time signal, the signal must be interpolated to provide signal samples at intermediate time displacements between the known signal samples.

Known interpolators of discrete time signals embody Finite Impulse Response Filters, wherein known signal samples are fed to a shift register embodied therein and, in accordance with the values of the signal samples present in the shift register, an interpolation process is provided to generate interpolated signal samples at intermediate time displacements. Interpolated signal samples are calculated by convolving the discrete time signal samples held in the shift register with an impulse response representative of the interpolating function.

A known technique for providing a reduction in complexity of such interpolating filters or indeed of any Finite Impulse Response (FIR) filter wherein the impulse response of the filter has a linear phase is known as 'pre-addition'. A characteristic of a linear phase impulse response is that coefficients of the impulse response have a symmetrical distribution about a centre or reference point. A pre-addition structure utilises the symmetry of the linear phase impulse response which is characterised in that each impulse response coefficient ai is equal to an impulse response coefficient in an equivalent temporal position about a centre or reference coefficient point. Thus for a linear phase impulse response ai = $a_{-i}$. The pre-addition structure operates to provide a reduced complexity interpolator by summing pairs of discrete time signal samples held within the shift register of the FIR interpolator, before multiplication by impulse response coefficients wherein the pairs of signal samples correspond to symmetrical pairs of impulse response coefficients of the interpolator, or, in other words, where ai is equal to $a_{-i}$.

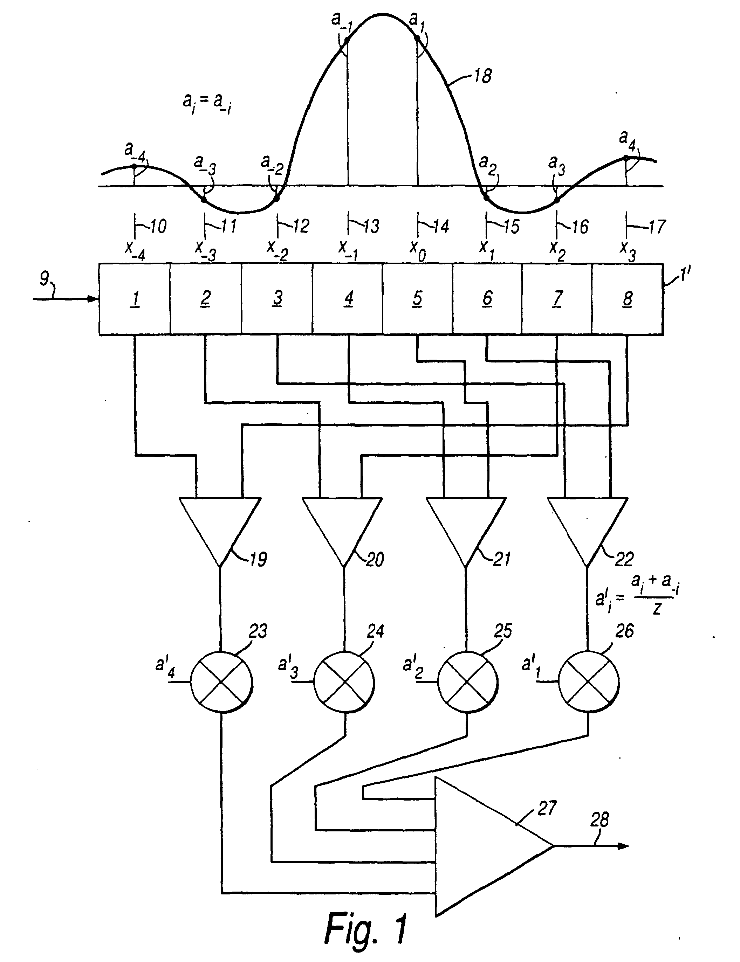

FIGURE 1 presents an illustrative example of a Finite Impulse Response interpolating filter, with a pre-addition structure. In Figure 1, a shift register 1' is shown to be comprised of eight stages 1, 2, 3, 4, 5, 6, 7, 8, fed with discrete time signal samples via a conductor 9. Also shown in Figure 1 is a set of lines 10, 11, 12, 13, 14, 15, 16, 17, each of which is representative of a discrete reference corresponding in time to the relative position of each of the stages 1, 2, 3, 4, 5, 6, 7, 8, of the shift register 1'. Each of the lines, 10, 11, 12, 13, 14, 15, 16, 17, is shown with a signal sample represented as xi where i represents the relative position in time of the impulse response of the filter with respect to a central or reference point $x_0$. Also shown in Figure 1, is a conceptual line 18, representative of an interpolating function. The interpolating function 18, is shown to be symmetrical about the central or reference position $y_0$, which corresponds to a temporal position of a interpolated signal sample to be calculated. As a result of the symmetry of the interpolating function 18, each of the coefficients representative of the impulse response of the interpolating function is symmetrical as aforementioned in that $a_1 = a_{-1}$, $a_2 = a_{-2}$ and so forth such that ai = $a_{-i}$. Connected to the shift register 1' is a plurality of summing amplifiers 19, 20, 21, 22 which operate to form a pre-addition of discrete time signal samples for corresponding coefficients of the impulse response of the interpolation function 18 which are symmetrical in that $a_i = a_{-i}$ At an output of each of the summing amplifiers 19, 20, 21, 22 the pre-addition sum is subsequently scaled by corresponding composite coefficient $a_i$ of the interpolating function by a corresponding plurality of multipliers 23, 24, 25, 26. Each output from the multipliers 23, 24, 25, 26, is fed to a final summer 27, which operates to sum the respective outputs from the multipliers to produce the interpolated signal sample $y_0$ at a conductor 28.

The pre-addition structure, as illustrated by the Finite Impulse Response interpolating filter shown in Figure 1, therefore provides a saving in the order of a factor of two in complexity, cost and time for interpolation. This saving is achieved by pre-adding each pair of discrete time signal samples $x_i$ associated with a corresponding pair of symmetrical impulse response coefficients $a_i$ and multiplying these pre-added samples by one of the pair of corresponding impulse response coefficients. The result of such multiplications for each pair of discrete time signal samples are thereafter summed to form an interpolated signal sample.

An interpolating Finite Impulse Response filter, which is provided with a pre-addition structure as hereinbefore described, would have an advantage of a reduced complexity implementation. However, provision of a pre-addition structure is conditioned on the impulse response of the interpolating filter being a linear phase response and thereby possessing a necessary symmetry. Although an interpolation function of an interpolating filter may exhibit a linear phase, an impulse response representative of a sampled version of the interpolation function may not be symmetrical about an interpolation point of the function, corresponding to a temporal position of a interpolated sample, preventing the use of a pre-addition structure.

It is an object of the present invention, as defined by the method according to claim 1 and the interpolating filter according to claim 11, to provide a reduced complexity interpolator.

According to the present invention, there is provided a method of interpolating a discrete time signal comprising steps of; (i) identifying a plurality of interpolation points which interpolation points are substantially equally temporally displaced about a central reference point ($x_0$) of a plurality of discrete time samples of ($x_{-4}$ to $x_3$) of a signal for which interpolated signal samples ($y_0$, $y_1$) are to be calculated at the said interpolation points; (ii) for each of the interpolation points, determining a plurality of impulse response coefficients ($a_{-4}$ to $a_4$) appertaining to an interpolating function at each corresponding sampling time of the said plurality of signal samples ($x_{-4}$ to $x_3$), and (iii) contemporaneously calculating the interpolated signal samples ($y_0$, $y_1$) corresponding to the interpolation points in combination with sum and difference operations of at least one pair of impulse response coefficients, and at least one pair of discrete time signal samples, wherein step (iii) of the said method comprises the steps of; (iv) forming first intermediate data $\alpha$, in accordance with at least one summed pair of discrete time signal samples, in combination with at least one summed pair of corresponding impulse response coefficients; (v) forming second intermediate data $\beta$, in accordance with a difference between at least one pair of discrete time signal samples, in combination with a difference between at least one pair of corresponding impulse response coefficients, and (vi) calculating the interpolated signal samples in accordance with a sum of the first intermediate data $\alpha$, and the second intermediate data $\beta$, and a difference between the first intermediate data $\alpha$, and the second intermediate data $\beta$.

By selecting a plurality of interpolating points, each of which is displaced in time by an equal amount from a central reference point, the calculation of interpolated signal samples corresponding to the interpolation points may be substantially reduced by utilising a relative symmetry of the impulse response coefficients associated with respective interpolation points.

According to the invention there is also provided an interpolating filter for generating a plurality of interpolated signal samples ($y_0$, $y_1$) of a discrete time signal, comprises a shift register, which shift register serves to store samples ($x_{-4}$ to $x_3$) of the discrete time signal fed thereto, a plurality of switchable adder/subtractors connected to the said shift register, each of which said adder/subtractors operates in a first mode to add a pair of signal samples communicated from the shift register which pair of signal samples are substantially equally temporally displaced about a central reference point, and in a second mode to subtract the pair of signal samples from each other, and which adder/subtractors are switched between first and second modes in accordance with a control signal, a plurality of scaling means, each of which scaling means operates to scale signals communicated from an output of a respective one of the said adder/subtractors with data communicated from one of a plurality of controllable switches, the data fed from each controllable switch being either a sum of two interpolating coefficients in a first position of the said switch for scaling signals generated by the respective adder/subtractor when operating in the first mode, or a difference between the interpolating coefficients in a second position of the said switch for scaling signals generated by the respective adder/subtractor when operating in the second mode, which position of the switch is controlled in accordance with the said control signal, a summer connected to an output of each of the plurality of scaling means, which summer operates to sum scaled outputs from the said adder/subtractors, and an interpolating controller which operates to generate the control signal and the interpolated signal samples in accordance with the sum and difference operations on signals provided at an output of the summer.

One embodiment of the present invention will now be described by way of example only, with reference to the accompanying drawings wherein;

Figure 2 is a representation of two versions of an interpolation function with associated coefficients corresponding to two interpolating points for an odd order interpolator.

FIGURE 3 is a representation of two versions of an interpolation function with associated coefficients corresponding to two interpolating points, for an even order interpolator, and

FIGURE 4 is a schematic block diagram of an even order interpolating filter.

A Finite Impulse Response Filter (FIR) which operates to convolve an impulse response of the filter with a discrete time signal may be an even order filter or an odd order filter. An even order filter comprises an impulse response with an even number of impulse response coefficients whereas an odd order filter embodies an impulse response with an odd number of impulse coefficients. An odd order impulse response is characterised by a fact that a discrete time sample will lie at a central point of the impulse response of the filter. An even order impulse response is characterised in that a sample does not lie at a central point of the impulse response of the filter.

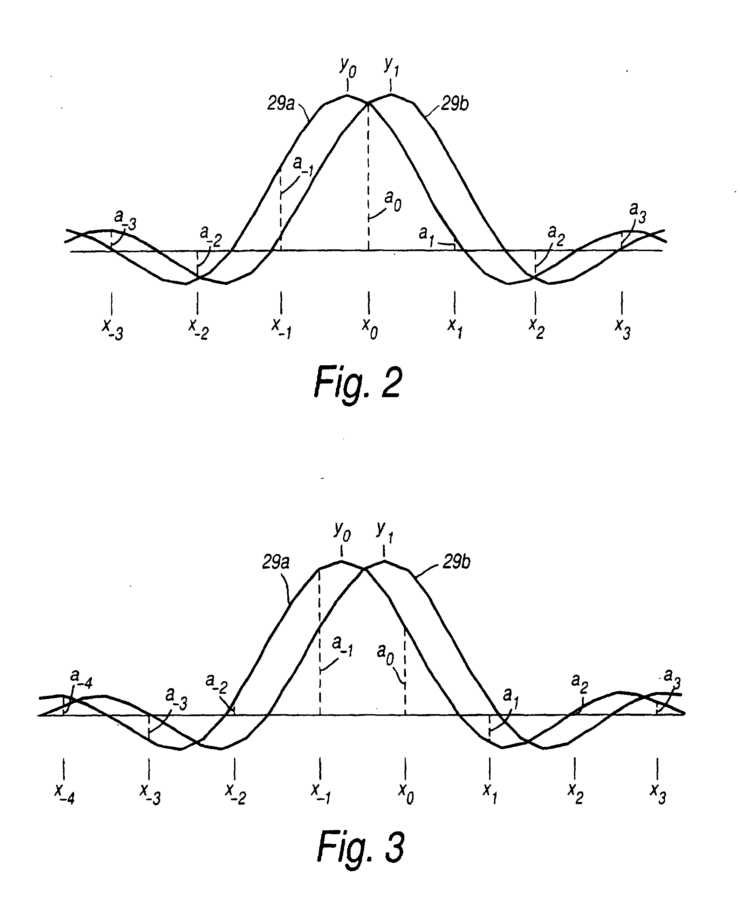

An illustrative representation of an interpolation function in continuous time form is shown in Figure 2. In Figure 2 two versions of the interpolating function are shown 29a, 29b, which correspond to a calculation of two interpolated signal samples $y_0$ $y_1$. Also shown in Figure 2, are a plurality of discrete time sampling points represented by lines which are labelled with $x_{-i}$ where index i is in the range -3 to 3. In this case an interpolator for interpolating the signal sample is an odd order interpolator. At each of the discrete time sampling points $x_{-3}$, $x_{-2}$, $x_{-1}$, $x_0$, $x_1$, $x_2$, $x_3$, a corresponding sample of the interpolating functions 29a, 29b is shown by impulse response coefficient ai where i is also in the range -3 to 3. The impulse response coefficients, $a_i$ form an impulse response corresponding to a discrete time representation of the interpolating function 29a, 29b which serve to form interpolated samples $y_0$, $y_1$. As a result of the fact that the interpolated sampling points $y_0$ $y_1$ are temporarily displaced with respect to the discrete time sample instant xo by an equal amount, the impulse response coefficient for each of the interpolating points $y_1$, $y_0$ are substantially the same, in that the coefficient $a_i$ where i is -3 to 3 are the same for a calculation of an interpolating sample at the interpolation point $y_0$ as they are for the interpolating point $y_1$. The coefficients for calculation of respective interpolated samples $y_0$ $y_1$ are therefore symmetrical. It is this symmetry between calculation of interpolated samples that provides a saving in computation of the interpolated samples at points $y_0$ $y_1$, in accordance with the following method.

In the example shown in Figure 2, the interpolation point $y_0$ corresponds to a temporal position, which is a quarter of the sampling interval earlier than a current input signal sample position corresponding to $x_o$.

The interpolator point $y_1$ corresponds to a temporal position, which is a quarter of the sampling interval later than the current input signal sample corresponding to $x_o$. The coefficients for the interpolation point are shown on the diagram as $a_i$ with $i \in \{-3...3\}$. Thus

$$y_0 = \sum_{i=-3}^{3} a_i x_i$$

and, more generally for an odd order interpolator:-

$$y_0 = \sum_{i=-k}^{k} a_i x_i$$

where the order of the filter is $2k+1$. Inspection of

Figure 2 shows a form of symmetry between the coefficients of the interpolation point for early samples $y_0$ and that for the interpolation point for late samples $y_1$.

Thus we can see that

$$y_1 = \sum_{i=-3}^{3} a_{-i} x_i$$

and, more generally:-

$$y_1 = \sum_{i=-k}^{k} a_{-i} x_i.$$

We
may express the above as follows:-

$$y_0 = a_0 x_0 + \sum_{i=-k}^{-1} a_i x_i + \sum_{i=1}^{k} a_i x_i = a_0 x_0 + \sum_{i=1}^{k} (a_i x_i + a_{-i} x_{-i})$$

and

$$y_1 = a_0 x_0 + \sum_{i=-k}^{-1} a_{-i} x_i + \sum_{i=1}^{k} a_{-i} x_i = a_0 x_0 + \sum_{i=1}^{k} (a_{-i} x_i + a_i x_{-i})$$

Now form

$$\alpha = \frac{y_o + y_1}{2} = a_0 x_0 + \frac{1}{2}\sum_{i=1}^{k}\left(a_i x_i + a_{-i} x_{-i} + a_{-i} x_i + a_i x_{-i}\right)$$

(1)

$$\alpha = a_0 x_0 + \frac{1}{2}\sum_{i=1}^{k}\left(a_i + a_{-i}\right)\left(x_i + x_{-i}\right) = \sum_{i=0}^{k} a_i^{'}\left(x_i + x_{-i}\right) \qquad (1)$$

wherein

$$a_i^{'} = \begin{cases} i = 0 & \dfrac{a_0}{2} \\[3mm] i > 0 & \dfrac{ai + a_{-i}}{2} \end{cases}$$

and
(2)

$$\beta = \frac{y_0 - y_1}{2} = \frac{1}{2}\sum_{i=1}^{k}\left(a_i x_i + a_{-i} x_{-i} - a_{-i} x_i - a_i x_{-i}\right)$$

$$\beta = \frac{1}{2}\sum_{i=1}^{k}\left(a_i - a_{-i}\right)\left(x_i - x_{-i}\right) = \sum_{i=0}^{k} a_i^{''}\left(x_i - x_{-i}\right) \qquad (2)$$

wherein

$$a_i^{''} \frac{a_i - a_{-i}}{2}.$$

The interpolated signal samples corresponding to the sampling points $y_0$, $y_1$ are thereafter calculated in accordance with the sum of $\alpha$ and $\beta$ for $y_0$, and a difference between $\alpha$ and $\beta$ for $y_1$ as represented by equations (5) and (6).

$$y_0 = \alpha + \beta \qquad (5)$$

$$y_1 = \alpha - \beta \qquad (6)$$

A representation of two versions of the interpolation function for calculation of two interpolated samples at positions $y_0$ $y_1$ for an even order impulse response is shown in Figure 3 where parts or elements also represented in Figure 2 bear identical numerical or alpha numeric designations. In Figure 3, the interpolating function 29a, 29b, are shown to be sampled in accordance with a plurality of discrete time sampling positions $x_i$ as for Figure 2, but unlike Figure 2, there are now eight sampling positions and correspondingly the impulse coefficients $a_i$ for each of these even number of sampling positions are adjusted in accordance with the temporal position of each of the discrete time sampling points $x_i$ where now ; is in the range -4 to +3. In this case we have

$$y_0 = \sum_{i=-k}^{k-1} a_i x_i$$

for a filter of order $2k$ ($k$=3 in Figure 3). With a symmetry similar to that described earlier, we have

$$y_1 = \sum_{i=-k}^{k-1} a_{-(i+1)} x_i.$$

We can express the above as:-

$$y_0 = \sum_{i=-k}^{-1} a_i x_i + \sum_{i=0}^{k-1} a_i x_i = \sum_{i=0}^{k-1} \left( a_i x_i + a_{-(i+1)} x_{-(i+1)} \right)$$

and

$$y_1 = \sum_{i=-k}^{-1} a_{-(i+1)} x_i + \sum_{i=0}^{k-1} a_{-(i+1)} x_i = \sum_{i=0}^{k-1} \left( a_{-(i+1)} x_i + a_i x_{-(i+1)} \right)$$

Now form

$$\alpha = \frac{y_0 + y_1}{2} = \frac{1}{2} \sum_{i=0}^{k-1} \left( a_i x_i + a_{-(i+1)} x_{-(i+1)} + a_{-(i+1)} x_i + a_i x_{-(i+1)} \right)$$

$$\alpha = \frac{1}{2} \sum_{i=0}^{k-1} \left( a_i + a_{-(i+1)} \right)\left( x_i + x_{-(i+1)} \right) = \sum_{i=1}^{k} a_i' \left( x_i + x_{-(i+1)} \right) \qquad (3)$$

where

$$a'_i = \frac{a_i + a_{-(i+1)}}{2}$$

$$\beta = \frac{y_0 - y_1}{2} = \frac{1}{2}\sum_{i=0}^{k-1}\left(a_i x_i + a_{-(i+1)} x_{-(i+1)} - a_{-(i+1)} x_i - a_i x_{-(i+1)}\right)$$

$$\beta = \frac{1}{2}\sum_{i=0}^{k-1}\left(a_i - a_{-(i+1)}\right)\left(x_i - x_{-(i+1)}\right) = \sum_{i=1}^{k} a_i^{\cdot}\left(x_i - x_{-(i+1)}\right) \qquad (4)$$

where

$$a''_i = \frac{a_i - a_{-(i+1)}}{2}$$

Thus, as for the odd interpolator case, we have $y_0 = \alpha + \beta$ and $y_1 = \alpha - \beta$ where $\alpha$ and $\beta$ are generated with only $k$ multiplications each.

Consider now a hardware (or software) implementation which uses the final expressions to generate $\alpha$ and $\beta$. For $\alpha$ we perform a pre-addition over the samples (for convenience, pre-adding the centre sample to itself) and multiply by the taps $a'_i$, $i \in \{0...k\}$. Thus we perform $k + I$ multiplications to form $\alpha$. For $\beta$ we perform a pre-subtraction over the samples (in this case the subtraction of the centre sample from itself gives zero so this term is ignored) and multiply the taps by $a''_i$, $i \in \{1...k\}$. Thus we perform $k$ multiplications to form $\beta$. In total we perform $2k + 1$ multiplications to generate $\alpha$ and $\beta$. Given $\alpha$ and $\beta$ we can easily derive $y_0$ and $y_1$ since $y_0 = \alpha + \beta$ and $y_1 = \alpha - \beta$. as hereinbefore explained. Thus we have generated both $y_0$ and $y_1$ by performing only $2k + 1$ multiplications whereas in the ordinary implementation, they would require $2k + 1$ multiplications each. Thus this approach leads to a halving of the number of multiplications.

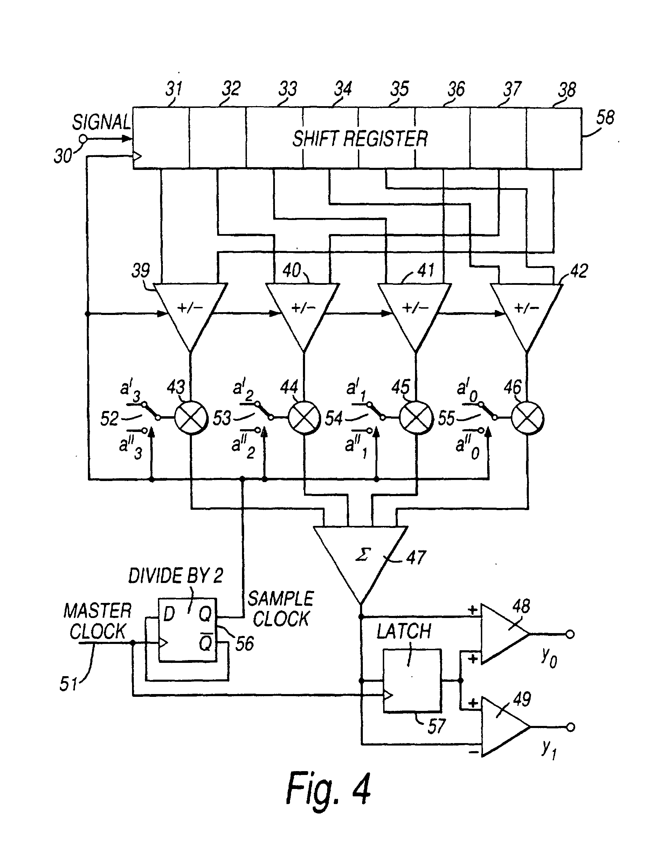

A corresponding implementation of a FIR interpolating filter for performing the interpolation of an even order impulse response is shown in Figure 4. The above approach for generating interpolated samples may be implemented in a variety of efficient hardware or software embodiments. Figure 4, shows the architecture for an 8th order ($k = 4$) interpolator hardware embodiment of an interpolater which operates in accordance with the interpolation method hereinbefore described for an even order interpolater.

In Figure 4 a discrete time signal is fed from a conductor 30, to a shift register 58, comprised of eight stages 31, 32, 33, 34, 35, 36, 37, 38. Also shown in Figure 4, are four controllable adder subtractors 39, 40, 41, 42. A first adder/subtractor 39, is connected to a first stage 31, and to the eighth stage 38, of the shift register 58. Adder subtractor 40, is connected to a second stage 32, and to the seventh stage 37, of the shift register 58, whereas the third adder subtractor 41, is connected to the third stage 33, and to the sixth stage 36, of the shift register 58. Finally, the fourth adder subtractor 42, is connected to the fourth stage 34, and to the fifth stage 35, of the shift register 58. An output of each of the four adder subtractors 39, 40, 41, 42, is respectively connected to an input of one of four multipliers 43, 44, 45 and 46. An output of each of the four multipliers 43, 44, 45, 46, is connected to an input of an adder 47. An output of the adder 47, is connected to one positive input of a first arithmetic unit 48. The output form the adder 47, is also connected to a negative input of a second arithmetic unit 49. The output from the adder 47 is also connected to an input of a latch 50. An output of the latch 50, is connected to a second positive input of the first arithmetic unit 48 and a second positive input of the second arithmetic unit 49. A clock input of the latch is connected to a master clock via a conductor 51, which is also connected to a clock input of a divide by two D-type flip-flop 56. A Q output of the D-type flip-flop is connected to a clock input of the shift register 58, and respectively to a control input of each of the adder subtractors 39, 40, 41, 42. The Q output from the D-type flip-flop is also connected to a control input of each of four switches 52, 53, 54, 55. An output from each of the switches 52, 53, 54, 55, is respectively connected to a second input of each of the multipliers 43, 44, 45, 46.

In Figure 4, the shift register 58. clock in signals samples, $x_i$, where $i \in \{-4...3\}$. The master clock runs at twice the sample rate. The sample clock which drives the shift register 58, is derived from a version of the master clock, which is divided by two by the divide by 2 flip-flop 56, to produce a sample clock representative of the master clock, but with half the frequency. On the rising edge of the sample clock a new signal sample is shifted into the shift register.

The four adder/subtractors 39,40,41,42, are arranged to output $x_i \pm x_{-(i+1)}$ depending on the state of the sample clock. An adder/subtractor adds its inputs together if configured to add (sample clock high) and subtracts the right hand input from the left hand input if configured to subtract (sample clock low). The rightmost adder/subtractor provides the output for $i = 0$ and the index increases from right to left. For each position, $i$, the output is multiplied by either $a'_i$ (if the adder/subtractor is adding) or $a''_i$ (if the adder/subtractor is subtracting). The choice of $a'_i$ or $a''_i$ is according to the state of the switches.

During the interval between successive cycles of the sample clock, there are two phases of the operation of the master clock. During the first phase the sample clock is high and the circuit is arranged to compute the current value of $\alpha$. The second phase begins with the next rising edge of the master clock. This clocks the value of $\alpha$ into the latch 57, and sets the sample clock low. In this state the circuit is arranged to compute the value of $\beta$. Once the computed value of $\beta$ becomes valid (towards the end of the master clock cycle), the outputs of the adder and subtractor provide $y_0 = \alpha + \beta$ and $y_1 = \alpha - \beta$ respectively. Thus, in this implementation, the two outputs are generated contemporaneously.

As will be appreciated by those skilled in the art various modifications may be made to the arrangement of the interpolating filter without departing from the scope of the invention as defined in the appended claims, in particular it may be appropriate to interpolate several values between the regular input samples. There may, nevertheless, remain a symmetry between the coefficients needed to generate half of a subset of these samples and the other half of that subset. The principles hereinbefore described may therefore be extended to this case by generating the same filtering operations to generate each suitable pair of interpolated values. Note, however, that a further saving is possible in this case because the required pre-addition and pre-subtraction operations are common to all required interpolated values. Thus these operations need only be performed once.

## Claims

1. A method of interpolating a discrete time signal comprising steps of;

    (i) identifying a plurality of interpolation points which interpolation points are substantially equally temporally displaced about a central reference point ($x_0$) of a plurality of discrete time samples of ($x_{-4}$ to $x_3$) of a signal for which interpolated signal samples ($y_0$, $y_1$) are to be calculated at the said interpolation points;
    (ii) for each of the interpolation points, determining a plurality of impulse response coefficients ($a_{-4}$ to $a_4$) appertaining to an interpolating function at each corresponding sampling time of the said plurality of signal samples ($x_{-4}$ to $x_3$), and
    (iii) contemporaneously calculating the interpolated signal samples ($y_0$, $y_1$) corresponding to the interpolation points in combination with sum and difference operations of at least one pair of impulse response coefficients, and at least one pair of discrete time signal samples, wherein step (iii) of the said method comprises the steps of;
    (iv) forming first intermediate data $\alpha$, in accordance with at least one summed pair of discrete time signal samples, in combination with at least one summed pair of corresponding impulse response coefficients;
    (v) forming second intermediate data $\beta$, in accordance with a difference between at least one pair of discrete time signal samples, in combination with a difference between at least one pair of corresponding impulse response coefficients, and
    (vi) calculating the interpolated signal samples in accordance with a sum of the first intermediate data $\alpha$, and the second intermediate data $\beta$, and a difference between the first intermediate data $\alpha$, and the second intermediate data $\beta$.

2. A method of interpolating a discrete time signal as claimed in claim 1, wherein the said plurality of impulse response co-efficients of the interpolation function determined in step (ii) of the said method, are substantially the same for each of the said interpolation points.

3. A method of interpolating a discrete time signal as claimed in claim 1, wherein the interpolation points ($y_0$, $y_1$) are substantially equally temporally displaced about one ($x_0$) of the plurality of discrete time samples ($x_{-4}$ to $x_3$).

4. A method of interpolating a discrete time signal as claimed in claim 1, 2 or 3, wherein each signal sample of the said pair of at least one pair of signal samples in step (iv) of the said method for forming the first intermediate data $\alpha$, is substantially equally temporally displaced with respect to the central reference point ($x_0$), and the said at least one pair of impulse response coefficients are representative of samples of the interpolation function at temporal positions appertaining the temporal displacement of the said at least one pair of signal samples with respect to the central reference point ($x_0$).

5. A method of interpolating a discrete time signal as claimed in any of claims 1 to 4, wherein each signal sample of the said pair of at least one pair of signal samples in step (v) of the said method for forming the second intermediate data $\beta$, is substantially equally temporally displaced with respect to the central reference point ($x_0$), and the said at least one pair of impulse response coefficients are representative of samples of the interpolation function at temporal positions appertaining the temporal displacement of the said at least one pair of signal samples with respect to the central reference point ($x_0$).

6. A method of interpolating a discrete time signal as claimed in any preceding claim, wherein each of the said pairs of signal samples in step (iv) of the said method for forming the first intermediate data $\alpha$, are substantially equal to the said pairs of signal samples in step (v) of the said method for forming the second intermediate data $\beta$.

7. A method of interpolating a discrete time signal as claimed in any preceding claim, wherein each of the said pairs of impulse response coefficients in step (iv) of the said method for forming the first intermediate data $\alpha$, are substantially the same as the said pairs of impulse response coefficients in step (v) of the said method for forming the second intermediate data $\beta$.

8. A method of interpolating a discrete time signal as claimed in Claim 7, wherein the plurality of discrete time signal samples is an odd number of signal samples represented as $2k + 1$, where $k$ is an integer, and step (iv) of the said method for forming the first intermediate data $\alpha$, is calculated in accordance with equation (1) as follows;

$$\alpha = a_0 x_0 + \frac{1}{2}\sum_{i=1}^{k}(a_i + a_{-i})(x_i + x_{-i}) = \sum_{i=0}^{k} a_i^{'}(x_i + x_{-i}) \qquad (1)$$

wherein

$$a_i^{'} = \begin{cases} i = 0 & \dfrac{a_0}{2} \\[3mm] i > 0 & \dfrac{a_i + a_{-i}}{2} \end{cases}$$

and where $a_i$ represents the i-th impulse response coefficient of the interpolation function, and $x_i$ represents the i-th signal sample, and step (v) of the said method for forming the second intermediate data $\beta$, is calculated in accordance with equation (2) as follows:

$$\beta = \frac{1}{2}\sum_{i=1}^{k}(a_i - a_{-i})(x_i - x_{-i}) = \sum_{i=0}^{k} a_i^{''}(x_i - x_{-i}) \qquad (2)$$

wherein

$$a_i^{''} = \frac{a_i - a_{-i}}{2}.$$

9. A method of interpolating a discrete time signal as claimed in claim 7, wherein the plurality of discrete time signal samples is an even number of signal samples represented as $2k$, where $k$ is an integer, and step (iv) of the said method for forming the first intermediate data $\alpha$, is calculated in accordance with equation (3) as follows; for

$$\alpha = \frac{1}{2}\sum_{i=0}^{k-1}(a_i + a_{-(i+1)})(x_i + x_{-(i+1)}) = \sum_{i=1}^{k} a_i^{'}(x_i + x_{-(i+1)}) \qquad (3)$$

where

$$a_i' = \frac{a_i + a_{-(i+1)}}{2}$$

and where $a_i$ represents the i-th impulse response coefficient of the interpolation function, and $x_i$ represents the i-th signal sample, and step (v) of the said method for forming the second intermediate data $\beta$, is calculated in accordance with equation (4) as follows;

$$\beta = \frac{1}{2}\sum_{i=0}^{k-1}\left(a_i - a_{-(i+1)}\right)\left(x_i - x_{-(i+1)}\right) = \sum_{i=1}^{k} a_i''\left(x_i - x_{-(i+1)}\right) \qquad (4)$$

where

$$a_i'' = \frac{a_i - a_{-(i+1)}}{2}.$$

10. A method of interpolating a discrete time signal as claimed in claims 8 or 9, wherein the plurality of interpolation poins are two interpolation points, designated $y_0$ and $y_1$, and wherein $y_0 = \alpha + \beta$ and $y_1 = \alpha - \beta$

11. An interpolating filter for generating a plurality of interpolated signal samples ($y_0$, $y_1$) of a discrete time signal, comprises a shift register (58), which shift register (58) serves to store samples ($x_{-4}$ to $x_3$) of the discrete time signal fed thereto, a plurality of switchable adder/subtractors (39 to 42) connected to the said shift register (58), each of which said adder/subtractors (39 to 42) operates in a first mode to add a pair of signal samples communicated from the shift register which pair of signal samples are substantially equally temporally displaced about a central reference point, and in a second mode to subtract the pair of signal samples from each other, and which adder/subtractors (39 to 42) are switched between first and second modes in accordance with a control signal, a plurality of scaling means (43 to 46), each of which scaling means (43 to 46) operates to scale signals communicated from an output of a respective one of the said adder/subtractors (39 to 42) with data communicated from one of a plurality of controllable switches (52 to 55), the data fed from each controllable switch (52 to 55) being either a sum of two interpolating coefficients in a first position of the said switch for scaling signals generated by the respective adder/subtractor when operating in the first mode, or a difference between the interpolating coefficients in a second position of the said switch for scaling signals generated by the respective adder/subtractor when operating in the second mode, which position of the switch (52 to 55) is controlled in accordance with the said control signal, a summer (47) connected to an output of each of the plurality of scaling means (43 to 46), which summer (47) operates to sum scaled outputs from the said adder/subtractors (29 to 42), and an interpolating controller (56) which operates to generate the control signal and the interpolated signal samples in accordance with the sum and difference operations on signals provided at an output of the summer.

**Patentansprüche**

1. Verfahren zum Interpolieren eines diskreten Zeitsignals, das die folgenden Schritte umfaßt:

    (i) Identifizieren mehrerer Interpolationspunkte, die um einen zentralen Referenzpunkt ($x_0$) mehrerer diskreter Zeitabtastwerte ($x_{-4}$ bis $x_3$) eines Signals, für das interpolierte Signalabtastwerte ($y_0$, $y_1$) an den Interpolationspunkten berechnet werden sollen, zeitlich im wesentlichen gleich verschoben sind;

    (ii) für jeden der Interpolationspunkte Bestimmen mehrerer Impulsantwortkoeffizienten ($a_{-4}$ bis $a_4$), die zu einer Interpolationsfunktion an jedem entsprechenden Abtastzeitpunkt der mehreren Signalabtastwerte ($x_{-4}$ bis $x_3$) gehören, und

    (iii) gleichzeitiges Berechnen der interpolierten Signalabtastwerte ($y_0$, $y_1$), die den Interpolationspunkten entsprechen, in Kombination mit Summen- und Differenzoperationen wenigstens eines Paars von Impulsantwortkoeffizienten und wenigstens eines Paars diskreter Zeitsignal-Abtastwerte, wobei der Schritt (iii) des Verfahrens die folgenden Schritte umfaßt:

(iv) Bilden erster Zwischendaten $\alpha$ in Übereinstimmung mit wenigstens einem summierten Paar diskreter Zeitsignal-Abtastwerte in Kombination mit wenigstens einem summierten Paar entsprechender Impulsantwortkoeffizienten;

(v) Bilden zweiter Zwischendaten $\beta$ in Übereinstimmung mit einer Differenz zwischen wenigstens einem Paar diskreter Zeitsignal-Abtastwerte in Kombination mit einer Differenz zwischen wenigstens einem Paar entsprechender Impulsantwortkoeffizienten, und

(vi) Berechnen der interpolierten Signalabtastwerte in Übereinstimmung mit einer Summe aus den ersten Zwischendaten $\alpha$ und den zweiten Zwischendaten $\beta$ und einer Differenz zwischen den ersten Zwischendaten $\alpha$ und den zweiten Zwischendaten $\beta$.

2.  Verfahren zum Interpolieren eines diskreten Zeitsignals nach Anspruch 1, bei dem die mehreren Impulsantwortkoeffizienten der Interpolationsfunktion, die im Schritt (ii) des Verfahrens bestimmt werden, für jeden der Interpolationspunkte im wesentlichen gleich sind.

3.  Verfahren zum Interpolieren eines diskreten Zeitsignals nach Anspruch 1, bei dem die Interpolationspunkte ($y_0$, $y_1$) um einen ($x_0$) der mehreren diskreten Zeitabtastwerte ($x_{-4}$ bis $x_3$) zeitlich im wesentlichen gleich verschoben sind.

4.  Verfahren zum Interpolieren eines diskreten Zeitsignals nach Anspruch 1, 2 oder 3, bei dem jeder Signalabtastwert des Paars aus wenigstens einem Paar von Signalabtastwerten im Schritt (iv) des Verfahrens zum Bilden der ersten Zwischendaten $\alpha$ in bezug auf den zentralen Referenzpunkt ($x_0$) zeitlich im wesentlichen gleich verschoben ist und das wenigstens eine Paar von Impulsantwortkoeffizienten Abtastwerte der Interpolationsfunktion an zeitlichen Positionen repräsentiert, die der zeitlichen Verschiebung des wenigstens einen Paars von Signalabtastwerten in bezug auf den zentralen Referenzpunkt ($x_0$) entsprechen.

5.  Verfahren zum Interpolieren eines diskreten Zeitsignals nach einem der Ansprüche 1 bis 4, bei dem jeder Signalabtastwert des Paars aus wenigstens einem Paar von Signalabtastwerten im Schritt (v) des Verfahrens zum Bilden der zweiten Zwischendaten $\beta$ in bezug auf den zentralen Referenzpunkt ($x_0$) zeitlich im wesentlichen gleich verschoben ist und das wenigstens eine Paar von Impulsantwortkoeffizienten Abtastwerte der Interpolationsfunktion an zeitlichen Positionen repräsentiert, die zu der zeitlichen Verschiebung des wenigstens einen Paars von Signalabtastwerten in bezug auf den zentralen Referenzpunkt ($x_0$) gehören.

6.  Verfahren zum Interpolieren eines diskreten Zeitsignals nach einem vorhergehenden Anspruch, bei dem jedes der Paare von Signalabtastwerten im Schritt (iv) des Verfahrens zum Bilden der ersten Zwischendaten $\alpha$ im we-sentlichen gleich einem der Paare von Signalabtastwerten im Schritt (v) des Verfahrens zum Bilden der zweiten Zwischendaten $\beta$ ist.

7.  Verfahren zum Interpolieren eines diskreten Zeitsignals nach einem vorhergehenden Anspruch, bei dem jedes der Paare von Impulsantwortkoeffizienten im Schritt (iv) des Verfahrens zum Bilden der ersten Zwischendaten $\alpha$ im wesentlichen gleich einem der Paare von Impulsantwortkoeffizienten im Schritt (v) des Verfahrens zum Bilden der zweiten Zwischendaten $\beta$ ist.

8.  Verfahren zum Interpolieren eines diskreten Zeitsignals nach Anspruch 7, bei dem die mehreren diskreten Zeitsignal-Abtastwerte in einer ungeraden Anzahl von Signalabtastwerten vorhanden sind, die durch $2k + 1$ repräsentiert werden, wobei $k$ eine ganze Zahl ist, und im Schritt (iv) des Verfahrens zum Bilden der ersten Zwischendaten $\alpha$ die Berechnung in Übereinstimmung mit der folgenden Gleichung (1) erfolgt:

$$\alpha = a_0 x_0 + \frac{1}{2}\sum_{i=1}^{k}(a_i + a_{-i})(x_i + x_{-i}) = \sum_{i=0}^{k} a_i^{\cdot}(x_i + x_{-i}) \qquad (1)$$

wobei

$$a_i^{\cdot} = \begin{cases} i = 0 & \dfrac{a_0}{2} \\[3mm] i > 0 & \dfrac{ai + a_{-i}}{2} \end{cases}$$

und wobei $a_i$ den i-ten Impulsantwortkoeffizienten der Interpolationsfunktion repräsentiert und $x_i$ den i-ten Signalabtastwert repräsentiert, und die Berechnung im Schritt (v) des Verfahrens zum Bilden der zweiten Zwischendaten $\beta$ in Übereinstimmung mit der folgenden Gleichung (2) erfolgt:

$$\beta = \frac{1}{2}\sum_{i=1}^{k}(a_i - a_{-i})(x_i - x_{-i}) = \sum_{i=0}^{k} a_i^{\cdot}(x_i - x_{-i}) \qquad (2)$$

wobei

$$a_i^{"} = \frac{a_i - a_{-i}}{2}$$

9.  Verfahren zum Interpolieren eines diskreten Zeitsignals nach Anspruch 7, bei dem die mehreren Zeitsignal-Abtastwerte in einer geraden Anzahl von Signalabtastwerten vorhanden sind, die durch $2k$ repräsentiert wird, wobei $k$ eine ganze Zahl ist, und die Berechnung im Schritt (iv) des Verfahrens zum Bilden der ersten Zwischendaten $\alpha$ in Übereinstimmung mit der folgenden Gleichung (3) erfolgt:

$$\alpha = \frac{1}{2}\sum_{i=0}^{k-1}(a_i + a_{-(i+1)})(x_i + x_{-(i+1)}) = \sum_{i=1}^{k} a_i^{\cdot}(x_i + x_{-(i+1)}) \qquad (3)$$

wobei

$$a_i^{\prime} = \frac{a_i + a_{-(i+1)}}{2}$$

und wobei $a_i$ den i-ten Impulsantwortkoeffizienten der Interpolationsfunktion repräsentiert und $x_i$ den i-ten Signalabtastwert repräsentiert, und die Berechnung im Schritt (v) des Verfahrens zum Bilden der zweiten Zwischendaten $\beta$ in Übereinstimmung mit der folgenden Gleichung (4) erfolgt:

$$\beta = \frac{1}{2}\sum_{i=0}^{k-1}\left(a_i - a_{-(i+1)}\right)\!\left(x_i - x_{-(i+1)}\right) = \sum_{i=1}^{k} a_i^{\cdot}\!\left(x_i - x_{-(i+1)}\right) \qquad (4)$$

wobei

$$a_i' = \frac{a_i - a_{-(i+1)}}{2}$$

10. Verfahren zum Interpolieren eines diskreten Zeitsignals nach den Ansprüchen 8 oder 9, bei dem die mehreren Interpolationspunkte zwei Interpolationspunkte sind, die mit $y_0$ und $y_1$ bezeichnet sind, und bei dem $y_0 = \alpha + \beta$ und $y_1 = \alpha - \beta$.

11. Interpolationsfilter zum Erzeugen mehrerer interpolierter Signalabtastwerte ($y_0$, $y_1$) eines diskreten Zeitsignals, mit einem Schieberegister (58), das dazu dient, Abtastwerte ($x_{-4}$ bis $x_3$) des an es geliefertem diskreten Zeitsignals zu speichern, mehreren umschaltbaren Addierern/Subtrahierern (39 bis 42), die an das Schieberegister (58) angeschlossen sind und wovon jeder in einer ersten Betriebsart arbeitet, um ein Paar Signalabtastwerte, die vom Schieberegister geliefert werden und um einen zentralen Referenzpunkt zeitlich im wesentlichen gleich verschoben sind, zu addieren, und in einer zweiten Betriebsart arbeitet, um das Paar von Signalabtastwerten voneinander zu subtrahieren, wobei die Addierer/Subtrahierer (39 bis 42) zwischen der ersten und der zweiten Betriebsart in Übereinstimmung mit einem Steuersignal umgeschaltet werden, mehreren Skalierungsmitteln (43 bis 46), wovon jedes in der Weise arbeitet, daß es Signale, die von einem Ausgang eines entsprechenden der Addierer/Subtrahierer (39 bis 42) geliefert werden, mit Daten, die von einem von mehreren steuerbaren Schaltern (52 bis 55) geliefert werden, skaliert, wobei die von jedem steuerbaren Schalter (52 bis 55) gelieferten Daten entweder, in einer ersten Stellung des Schalters, eine Summe zweier Interpolationskoeffizienten sind, um von dem entsprechenden Addierer/Subtrahierer erzeugte Signale zu skalieren, wenn er in der ersten Betriebsart arbeitet, oder, in einer zweiten Stellung des Schalters, eine Differenz zwischen den Interpolationskoeffizienten sind, um von dem entsprechenden Addierer/Subtrahierer erzeugte Signale zu skalieren, wenn er in der zweiten Betriebsart arbeitet, wobei die Stellung des Schalters (52 bis 55) in Übereinstimmung mit dem Steuersignal gesteuert wird, einem Summierer (47), der an einen Ausgang jedes der mehreren Skalierungsmittel (43 bis 46) angeschlossen ist und in der Weise arbeitet, daß er skalierte Ausgänge von den Addierern/Subtrahieren (29 bis 42) summiert, und einer Interpolationssteuereinheit (56), die in der Weise arbeitet, daß sie das Steuersignal und die interpolierten Signalabtastwerte in Übereinstimmung mit den Summenund Differenzoperationen an am Ausgang des Summierers bereitgestellten Signalen erzeugt.

**Revendications**

1. Procédé d'interpolation d'un signal temporel discret, comprenant.les étapes consistant à :

(i) identifier une pluralité de points d'interpolation, lesquels points d'interpolation sont substantiellement déplacés de manière uniforme dans le temps autour d'un point de référence central ($x_0$) d'une pluralité d'échantillons de temps discrets de ($x_{-4}$ à $x_3$) d'un signal pour lesquels des échantillons de signal interpolés ($y_0$, $y_1$) sont à calculer auxdits points d'interpolation ;
(ii) déterminer, pour chacun des points d'interpolation, une pluralité de coefficients de réponse impulsionnelle ($a_{-4}$ à $a_4$) appartenant à une fonction d'interpolation à chaque temps d'échantillonnage correspondant de ladite pluralité d'échantillons de signal ($x_{-4}$ à $x_3$), et
(iii) calculer simultanément les échantillons de signal interpolés ($y_0$, $y_1$) correspondant aux points d'interpolation en combinaison avec des opérations d'addition et de soustraction d'au moins une paire de coefficients de réponse impulsionnelle, et au moins une paire d'échantillons de signal temporel discret, dans lesquels l'étape (iii) dudit procédé comprend les étapes consistant à :
(iv) former des premières données intermédiaires $\alpha$, suivant au moins une paire additionnée d'échantillons de signal temporel discret, en combinaison avec au moins une paire additionnée de coefficients de réponse impulsionnelle correspondants ;

(v) former des deuxièmes données intermédiaires β, suivant une différence entre au moins une paire d'échantillons de signal temporel discret, en combinaison avec une différence entre au moins une paire de coefficients de réponse impulsionnelle correspondants, et

(vi) calculer les échantillons de signal interpolés suivant une somme des premières données intermédiaires α et des deuxièmes données intermédiaires β, et une différence entre les premières données intermédiaires α et les deuxièmes données intermédiaires β,

**2.** Procédé d'interpolation d'un signal temporel discret selon la revendication 1, dans lequel lesdits plusieurs coefficients de réponse impulsionnelle de la fonction d'interpolation déterminée dans l'étape (ii) dudit procédé, sont substantiellement les mêmes pour chacun desdits points d'interpolation.

**3.** Procédé d'interpolation d'un signal temporel discret selon la revendication 1, dans lequel les points d'interpolation $(y_0, y_1)$ sont substantiellement déplacés de manière uniforme dans le temps autour d'une pluralité d'échantillons de temps discrets $(x_{-4}$ à $x_3)$.

**4.** Procédé d'interpolation d'un signal temporel discret selon la revendication 1, 2 ou 3, dans lequel chaque échantillon de signal de ladite paire d'au moins une paire d'échantillons de signal dans l'étape (iv) dudit procédé pour former les premières données intermédiaires α est substantiellement déplacé de manière uniforme dans le temps par rapport au point de référence central $(x_0)$, et ladite au moins une paire de coefficients de réponse impulsionnelle sont représentatifs d'échantillons de la fonction d'interpolation à des positions temporelles appartenant au déplacement temporel de ladite au moins une paire d'échantillons de signal par rapport au point de référence central $(x_0)$.

**5.** Procédé d'interpolation d'un signal temporel discret selon l'une quelconque des revendications 1 à 4, dans lequel chaque échantillon de signal de ladite paire d'au moins une paire d'échantillons de signal dans l'étape (v) dudit procédé pour former les deuxièmes données intermédiaires β est substantiellement déplacé de manière uniforme dans le temps par rapport au point de référence central $(x_0)$, et ladite au moins une paire de coefficients de réponse impulsionnelle sont représentatifs d'échantillons de la fonction d'interpolation à des positions temporelles appartenant au déplacement temporel de ladite au moins une paire d'échantillons de signal par rapport au point de référence central $(x_0)$.

**6.** Procédé d'interpolation d'un signal temporel discret selon l'une quelconque des revendications précédentes, dans lequel chacune desdites paires d'échantillons de signal dans l'étape (iv) dudit procédé pour former les premières données intermédiaires α sont substantiellement égales auxdites paires d'échantillons de signal dans l'étape (v) dudit procédé pour former les deuxièmes données intermédiaires β.

**7.** Procédé d'interpolation d'un signal temporel discret selon l'une quelconque des revendications précédentes, dans lequel chacune desdites paires de coefficients de réponse impulsionnelle dans l'étape (iv) dudit procédé pour former les premières données intermédiaires α sont substantiellement les mêmes que lesdites paires de coefficients de réponse impulsionnelle dans l'étape (v) dudit procédé pour former les deuxièmes données intermédiaires β.

**8.** Procédé d'interpolation d'un signal temporel discret selon la revendication 7, dans lequel ladite pluralité d'échantillons de signal temporel discret est un nombre impair d'échantillons de signal représenté par 2k + 1, où k est un nombre entier, et l'étape (iv) dudit procédé pour former les premières données intermédiaires α, est calculée suivant l'équation (1) comme suit :

$$\alpha = a_0 x_0 + \frac{1}{2}\sum_{i=1}^{k}(a_i + a_{-i})(x_i + x_{-i}) = \sum_{i=0}^{k} a_i^{'}(x_i + x_{-i}) \qquad (1)$$

dans laquelle

$$a_i^{'} = \begin{cases} i = 0 & \dfrac{a_0}{2} \\ i > 0 & \dfrac{ai + a_{-i}}{2} \end{cases}$$

et où $a_i$ représente le $i^{\text{ième}}$ coefficient de réponse impulsionnelle de la fonction d'interpolation, et $x_i$ représente le $i^{\text{ième}}$ échantillon de signal, et l'étape (v) dudit procédé pour former les deuxièmes données intermédiaires $\beta$, est calculée suivant l'équation (2) comme suit :

$$\beta = \frac{1}{2}\sum_{i=1}^{k}(a_i - a_{-i})(x_i - x_{-i}) = \sum_{i=0}^{k} a_i^{''}(x_i - x_{-i}) \qquad (2)$$

dans laquelle

$$a_i^{''} = \frac{a_i - a_{-i}}{2}$$

9. Procédé d'interpolation d'un signal temporel discret selon la revendication 7, dans lequel ladite pluralité d'échantillons de signal temporel discrets est un nombre pair d'échantillons de signal représenté par 2k, où k est un nombre entier, et l'étape (iv) dudit procédé pour former les premières données intermédiaires $\alpha$, est calculée suivant l'équation (3) comme suit : pour

$$\alpha = \frac{1}{2}\sum_{i=0}^{k-1}(a_i + a_{-(i+1)})(x_i + x_{-(i+1)}) = \sum_{i=1}^{k} a_i^{'}(x_i + x_{-(i+1)}) \qquad (3)$$

dans laquelle

$$a_i^{'} = \frac{a_i + a_{-(i+1)}}{2}$$

et où $a_i$ représente le $i^{\text{ième}}$ coefficient de réponse impulsionnelle de la fonction d'interpolation, et $x_i$ représente le $i^{\text{ième}}$ échantillon de signal, et l'étape (v) dudit procédé pour former les deuxièmes données intermédiaires $\beta$, est calculée suivant l'équation (4) comme suit :

$$\beta = \frac{1}{2}\sum_{i=0}^{k-1}(a_i - a_{-(i+1)})(x_i - x_{-(i+1)}) = \sum_{i=1}^{k} a_i^{''}(x_i - x_{-(i+1)}) \qquad (4)$$

dans laquelle

$$a_i'' = \frac{a_i - a_{-(i+1)}}{2}$$

**10.** Procédé d'interpolation d'un signal temporel discret selon la revendication 8 ou 9, dans lequel lesdits plusieurs points d'interpolation sont deux points d'interpolation, désignés $y_0$ et $y_1$ et dans lesquels $y_0 = \alpha + \beta$ et $y_1 = \alpha - \beta$.

**11.** Filtre d'interpolation pour générer une pluralité d'échantillons de signal interpolés ($y_0$, $y_1$) d'un signal temporel discret, comprenant un registre à décalage (58), lequel registre à décalage (58) sert à stocker des échantillons ($x_{-4}$ à $x_3$) du signal temporel discret qui y est appliqué, une pluralité d'additionneurs-soustracteurs commutables (39 à 42) connectés audit registre à décalage (58), chacun desdits additionneurs-soustracteurs (39 à 42) fonctionnant dans un premier mode pour ajouter une paire d'échantillons de signal communiqués par le registre à décalage, laquelle paire d'échantillons de signal est substantiellement déplacée de manière uniforme dans le temps autour d'un point de référence central, et dans un deuxième mode pour soustraire la paire d'échantillons de signal l'un de l'autre, et lesquels additionneurs-soustracteurs (39 à 42) sont commutés entre des premier et second modes suivant un signal de commande, une pluralité de moyens diviseurs (43 à 46), chacun des moyens diviseurs (43 à 46) fonctionnant pour diviser les signaux communiqués par une sortie d'un desdits additionneurs-soustracteurs respectifs (39 à 42) avec des données communiquées par un parmi plusieurs commutateurs contrôlables (52 à 55), les données délivrées par chaque commutateur contrôlable (52 à 55) étant soit une somme de deux coefficients d'interpolation dans une première position dudit commutateur pour diviser les signaux générés par l'additionneur-soustracteur respectif lorsqu'en fonctionnement dans le premier mode, soit une différence entre les coefficients d'interpolation dans une deuxième position dudit commutateur pour diviser des signaux générés par l'additionneur-soustracteur respectif lorsqu'en fonctionnement dans le deuxième mode, laquelle position du commutateur (52 à 55) est commandée suivant ledit signal de commande, un totalisateur (47) connecté à une sortie de chacun des plusieurs moyens diviseurs (43 à 46), lequel totalisateur (47) fonctionne pour totaliser des sorties divisées desdits additionneurs-soustracteurs (29 à 42), et un contrôleur d'interpolation (56) qui fonctionne pour générer le signal de commande et les échantillons de signal interpolés suivant les opérations d'addition et de différence sur les signaux délivrés à une sortie du totalisateur.

Fig. 1

*Fig. 2*

*Fig. 3*

*Fig. 4*